(19) Europäisches Patentamt
European Patent Office
Office européen des brevets

(11) **EP 4 742 846 A1**

(12) **EUROPEAN PATENT APPLICATION**

(43) Date of publication:
**13.05.2026 Bulletin 2026/20**

(21) Application number: **25195300.6**

(22) Date of filing: **12.08.2025**

(51) International Patent Classification (IPC):
**H05K 7/20** (2006.01)    **G02B 6/42** (2006.01)
**G06F 1/20** (2006.01)

(52) Cooperative Patent Classification (CPC):
**H05K 7/2039; G02B 6/4261; G02B 6/4269;
G06F 1/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **08.11.2024 JP 2024195795**

(71) Applicant: **Japan Aviation Electronics Industry,
Limited
Tokyo 150-0043 (JP)**

(72) Inventor: **HASHIGUCHI, Osamu
Tokyo, 150-0043 (JP)**

(74) Representative: **Vossius & Partner
Patentanwälte Rechtsanwälte mbB
Siebertstrasse 3
81675 München (DE)**

(54) **ELECTRONIC DEVICE**

(57)    There is provided a technique for bringing a heat sink and a plug shell into contact with each other without causing the heat sink and the plug shell to slide on each other with a simple configuration. In an electronic device 10, a heat sink 51 is supported to be movable in a first direction relative to a receptacle shell 61. A contact surface 25 of a plug shell 21 and a heat releasing surface of the heat sink 51 are formed as inclined surfaces. Pressing means 63 is disposed between the heat sink 51 and the receptacle shell 61. The receptacle shell 61 includes a guide portion (cam groove 62) configured to regulate movement of the heat sink 51 in a negative second direction when the heat sink 51 is at a position in a positive first direction relative to the receptacle shell 61, and to regulate movement of the heat sink 51 in a positive second direction when the heat sink 51 is at a position in a negative first direction relative to the receptacle shell 61. The heat sink 51 includes a guided portion (columnar protrusion 57) configured to be guided by the guide portion (cam groove 62) provided on the receptacle shell 61.

Fig. 1

EP 4 742 846 A1

**Description**

BACKGROUND OF THE INVENTION

Field of the Invention

The present invention relates to an electronic device.

Description of the Related Art

An electronic device in recent years is required to have higher heat dissipation efficiency because power consumption of mounted electronic parts is increased along with demands such as for increase in communication speed and improvement in processing performance. Therefore, it is desirable to provide an electronic device that can reasonably achieve a high heat dissipation effect only by contact between solids, like an optical transceiver including a heat sink or the like.

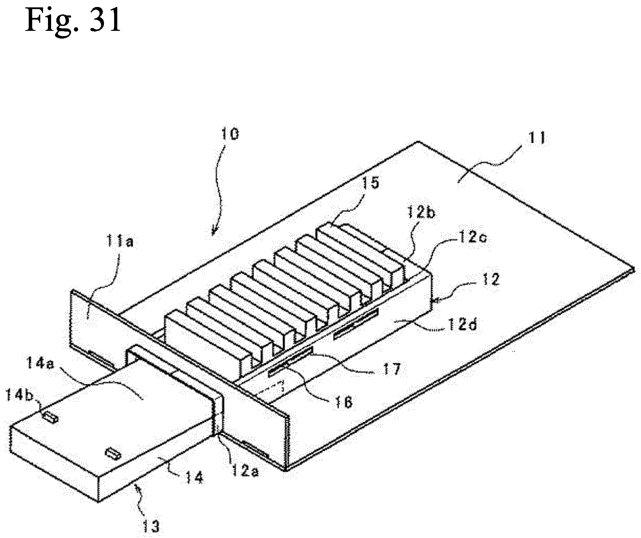

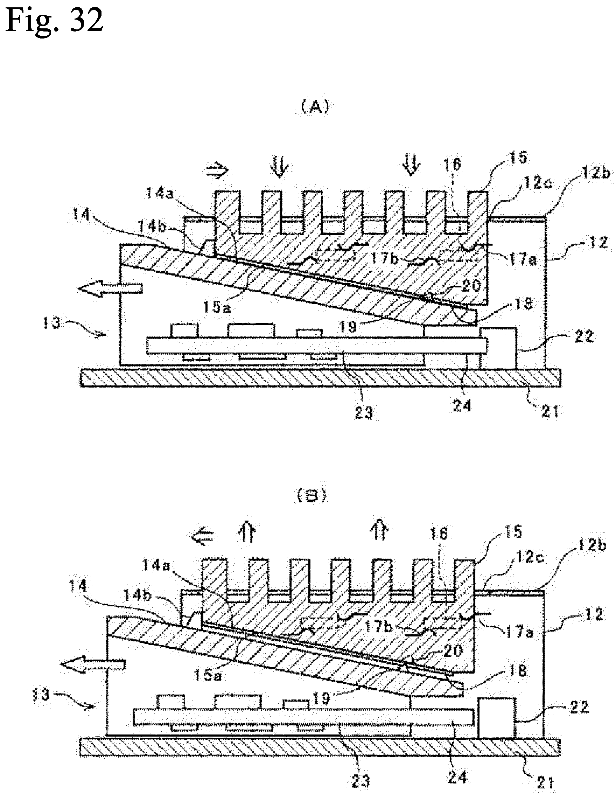

A structure of the electronic device of such a type is disclosed in, for example, Japanese Patent Laid-Open No. 2009-152427. In an optical transceiver (10) as an existing electronic device disclosed in Japanese Patent Laid-Open No. 2009-152427, a contact surface (15a) of a heat sink (15) and a contact surface (14a) of a transceiver housing (14) are formed as inclined surfaces, and a soft heat conductive sheet (18) is stuck to one of the contact surface (15a) of the heat sink (15) and the contact surface (14a) of the transceiver housing (14), as illustrated in FIG. 31 and FIG. 32. The heat sink (15) is supported by a cage (12) so as to be movable within a predetermined range in a front-rear direction and an up-down direction along with insertion of the transceiver housing (14). The transceiver housing (14) is inserted without rubbing a contact surface of the heat conductive sheet (18), and the contact surface of the heat sink (15) and the contact surface of the transceiver housing (14) are brought into press-contact with each other with the heat conductive sheet (18) in between at a final insertion position of the transceiver housing (14). Note that reference numerals relating to description of the related art document are distinguished from an embodiment of the present invention by adding parentheses.

In the optical transceiver (10) disclosed in Japanese Patent Laid-Open No. 2009-152427, since the heat sink (15) is supported by the cage (12) so as to be movable within the predetermined range in the front-rear direction and the up-down direction along with insertion of the transceiver housing (14), press-down springs (17a and 17b) are necessary. In addition, to prevent the heat conductive sheet (18) from being rubbed, components such as an engagement protrusion (19) and an engagement hole (20) are necessary, which complicates the configuration.

Therefore, an object of the present invention is to provide an electronic device that has a simple configuration and can bring a heat sink (a heat conductive sheet in the case where the heat conductive sheet is attached) and a plug shell into contact with each other without causing the heat sink and the plug shell to slide on each other.

SUMMARY OF THE INVENTION

An electronic device according to an aspect of the present invention includes: a plug connector including a plug shell and a plug housing; a receptacle housing including an opening into/from which the plug connector is insertable/extractable; and a heat sink movably installed on the receptacle housing by being installed through a receptacle shell attached to the receptacle housing. When the plug connector is inserted into the opening of the receptacle housing and a fitted state is established, a contact surface of the plug shell and a heat releasing surface of the heat sink come into contact with each other, and the heat sink dissipates heat generated from the plug connector. When an insertion/extraction direction of the plug connector into/from the opening of the receptacle housing is defined as a first direction, the extraction direction of the plug connector from the opening is defined as a positive first direction, the insertion direction is defined as a negative first direction, a direction orthogonal to the first direction is defined as a second direction, a direction in which the heat releasing surface of the heat sink is disposed relative to the plug shell in the fitted state is defined as a positive second direction, and a direction in which the plug shell is disposed relative to the heat releasing surface of the heat sink is defined as a negative second direction, the heat sink is supported to be movable in the first direction relative to the receptacle shell, the contact surface of the plug shell and the heat releasing surface of the heat sink are formed as inclined surfaces having inclination to the first direction, pressing means configured to press the heat sink in the positive first direction relative to the receptacle shell is disposed between the heat sink and the receptacle shell, the receptacle shell includes a guide portion configured to regulate movement of the heat sink in the negative second direction when the heat sink is at a position in the positive first direction relative to the receptacle shell, and to regulate movement of the heat sink in the positive second direction when the heat sink is at a position in the negative first direction relative to the receptacle shell, and the heat sink includes a guided portion configured to be guided by the guide portion provided on the receptacle shell.

In the electronic device according to a preferred embodiment of the present invention, the guide portion is preferably formed as a cam groove having a groove shape, the guided portion is preferably formed as a columnar protrusion to be fitted into the groove shape of the cam groove, and an expression of $\alpha \approx \beta$ is preferably established, where $\alpha$ is a second-direction dimension between a negative-second-direction part of the cam groove on the positive first direction side and a positive-second-direction part of the cam groove on the negative first direction side, and β is a second-direction dimension that is a diameter dimension of the columnar protrusion.

In other words, in the electronic device according to this preferred embodiment of the present invention, in a non-fitted state where the plug connector is not inserted into the opening of the receptacle housing, the heat sink is pressed in the positive first direction as the extraction direction by the pressing means that presses the heat sink in the positive first direction, the columnar protrusion abuts on the negative-second-direction part of the cam groove, and the heat sink is separated from the plug shell. When the plug connector is inserted into the opening of the receptacle housing in the negative first direction in such a state, the inclined surfaces that are the contact surface of the heat sink and the heat releasing surface of the plug shell come into contact with each other in the halfway fitted state. When the plug connector is further pressed in the negative first direction from the state where the inclined surfaces are in contact with each other, the columnar protrusion abuts on the positive-second-direction part of the cam groove, and the heat sink is pressed in the negative second direction side that is the plug shell side. Such a configuration does not require components such as press-down springs (17a and 17b), an engagement protrusion (19), and an engagement hole (20) that are necessary in the above-described existing technique. Thus, the configuration is simple and is easily manufactured at low cost. In a case where the plug connector is extracted from the opening of the receptacle housing, the pressing means presses the heat sink in the positive first direction, and the inclined surfaces of the heat sink and the plug shell are separated from each other. Therefore, the columnar protrusion moves inside the cam groove in the positive first direction, and the heat sink is returned to the position separated from the plug shell before fitting.

In the electronic device according to a preferred embodiment of the present invention, the plug housing may include a locking portion serving as fixing means, the receptacle housing may include a locked portion serving as fixed means, and when the plug connector is inserted into the opening of the receptacle housing and the fitted state is established, the locking portion and the locked portion engage with each other to maintain the fitted state of the plug connector to the receptacle housing against pressing force by the pressing means.

In the electronic device according to a preferred embodiment of the present invention, the pressing means can be configured as a member integrated with the receptacle shell.

In the electronic device according to a preferred embodiment of the present invention, the pressing means can be configured as a member separated from the receptacle shell.

In the electronic device according to a preferred embodiment of the present invention, the pressing means can be formed as a cantilever spring having a cantilever shape or a double-end supported spring having a double-end supported beam shape.

In the electronic device according to a preferred embodiment of the present invention, a heat conductive sheet can be installed on the heat releasing surface of the heat sink.

In the electronic device according to a preferred embodiment of the present invention, the guide portion formed as a cam groove can have a substantially L-shaped groove shape.

According to the present invention, it is possible to provide the electronic device that has a simple configuration and can bring the heat sink (a heat conductive sheet in the case where the heat conductive sheet is attached) and the plug shell into contact with each other without causing the heat sink and the plug shell to slide on each other.

BRIEF DESCRIPTION OF THE DRAWINGS

FIG. 1 is an appearance perspective view illustrating an entire configuration of an electronic device according to a present embodiment in a case where a state where a receptacle connector and a plug connector configuring the electronic device are fitted to each other is viewed from a front upper left side;

FIG. 2 is an appearance perspective view illustrating the entire configuration of the electronic device according to the present embodiment in a case where a state where the receptacle connector and the plug connector configuring the electronic device are not fitted to each other is viewed from the front upper left side;

FIG. 3 is an appearance perspective view in a case where the receptacle connector according to the present embodiment is viewed from the front upper left side;

FIG. 4 is an exploded perspective view illustrating a state where components of the receptacle connector according to the present embodiment illustrated in FIG. 3 are disassembled;

FIG. 5 is an appearance perspective view in a case where a heat sink that is a component of the receptacle connector according to the present embodiment is viewed from the front upper left side;

FIG. 6 is an appearance perspective view in a case where the heat sink that is the component of the receptacle connector according to the present embodiment is viewed from a front lower left side;

FIG. 7 is a left side view of the heat sink that is the component of the receptacle connector according to the present embodiment;

FIG. 8 is an appearance perspective view in a case where the receptacle shell that is the component of the receptacle connector according to the present embodiment is viewed from the front upper left side;

FIG. 9 is an appearance perspective view in a case where the receptacle shell that is the component of the receptacle connector according to the present embodiment is viewed from a rear lower left side;

FIG. 10 is a left side view of the receptacle shell that is the component of the receptacle connector according to the present embodiment;

FIG. 11 is an appearance perspective view in a case where the plug connector according to the present embodiment is viewed from the front upper left side;

FIG. 12 is an appearance perspective view in a case where the plug connector according to the present embodiment is viewed from a rear upper right side;

FIG. 13 is a top view of the plug connector according to the present embodiment;

FIG. 14 is a vertical cross-sectional left side view illustrating a cross-section taken along line XIV-XIV in FIG. 13;

FIG. 15 is a diagram for explaining operation of the electronic device according to the present embodiment in a case where a non-fitted state where the plug connector is not inserted into an opening of a receptacle housing is viewed from the front upper left side;

FIG. 16 is a top view for explaining operation of the electronic device according to the present embodiment in the non-fitted state where the plug connector is not inserted into the opening of the receptacle housing;

FIG. 17 is a left side view for explaining operation of the electronic device according to the present embodiment in the non-fitted state where the plug connector is not inserted into the opening of the receptacle housing;

FIG. 18 is a vertical cross-sectional left side view illustrating a cross-section taken along line XVIII-XVIII in FIG. 16;

FIG. 19 is a cross-sectional bottom view illustrating a cross-section taken along line XIX-XIX in FIG. 17;

FIG. 20 is a diagram for explaining operation of the electronic device according to the present embodiment in a case where a halfway fitted state where the plug connector is being inserted into the opening of the receptacle housing is viewed from the front upper left side;

FIG. 21 is a top view for explaining operation of the electronic device according to the present embodiment in the halfway fitted state where the plug connector is being inserted into the opening of the receptacle housing;

FIG. 22 is a left side view for explaining operation of the electronic device according to the present embodiment in the halfway fitted state where the plug connector is being inserted into the opening of the receptacle housing;

FIG. 23 is a vertical cross-sectional left side view illustrating a cross-section taken along line XXIII-XXIII in FIG. 21;

FIG. 24 is a cross-sectional bottom view illustrating a cross-section taken along line XXIV-XXIV in FIG. 22;

FIG. 25 is a diagram for explaining operation of the electronic device according to the present embodiment in a case where a fitted state where the plug connector is completely inserted into the opening of the receptacle housing is viewed from the front upper left side;

FIG. 26 is a top view for explaining operation of the electronic device according to the present embodiment in the fitted state where the plug connector is completely inserted into the opening of the receptacle housing;

FIG. 27 is a left side view for explaining operation of the electronic device according to the present embodiment in the fitted state where the plug connector is completely inserted into the opening of the receptacle housing;

FIG. 28 is a vertical cross-sectional left side view illustrating a cross-section taken along line XXVIII-XXVIII in FIG. 26;

FIG. 29 is a cross-sectional bottom view illustrating a cross-section taken along line XXIX-XXIX in FIG. 27;

FIG. 30 is a diagram for explaining operation of the electronic device according to the present embodiment and illustrating positional relationship of a columnar protrusion to a cam groove;

FIG. 31 is a schematic diagram for explaining an outline of a heat dissipation device included in an optical transceiver serving as an electronic device according to an existing technique; and

FIG. 32 is a diagram for explaining a configuration example relating to extraction of the optical transceiver serving as the electronic device according to the existing technique.

DETAILED DESCRIPTION OF THE INVENTION

A preferred embodiment for implementing the present invention is described below with reference to drawings. In the drawings, a first direction, a second direction, and a third direction are defined for convenience of description. In the present specification, the first direction is a front-rear direction. In the drawings, the front-rear direction is illustrated as a Y direction. In particular, a forward direction is a +Y direction, and a rearward direction is a -Y direction. The first direction is an insertion/extraction direction of a receptacle housing 41 and a plug connector 20 configuring an electronic device 10 according to the present embodiment. In other words, a direction in which the plug connector 20 is moved in the +Y direction (forward direction) relative to the receptacle housing 41 is the extraction direction, and a direction in which the plug connector 20 is moved in the -Y direction (rearward direction) relative to the receptacle housing 41 is the insertion direction.

In the present specification, the second direction is an up-down direction. In the drawings, the up-down direction is illustrated as a Z direction. In particular, an upward direction is a +Z direction, and a downward direction is a -Z direction. The second direction is a direction orthogonal to the first direction. In a fitted state where the plug connector 20 is inserted into an opening 42 of the receptacle housing 41 configuring the electronic device 10 according to the present embodiment, a direction in which a heat releasing surface of the heat sink 51 is disposed relative to a contact surface 25 of a plug shell 21 is a positive second direction (+Z direction (upward direction)), and a direction in which the contact surface 25 of the plug shell 21 is disposed relative to the heat releasing surface of the heat sink 51 is a negative second direction (-Z direction (downward direction)).

In the present specification, the third direction is a left-right direction. In the drawings, the left-right direction is illustrated as an X direction. In particular, a leftward direction is a +X direction, and a rightward direction is a -X direction. The Y direction as the first direction, the Z direction as the second direction, and the X direction as the third direction defined in the present specification do not limit directions during use of the electronic device 10 according to the present embodiment. The electronic device 10 according to the present embodiment can be used in all directions.

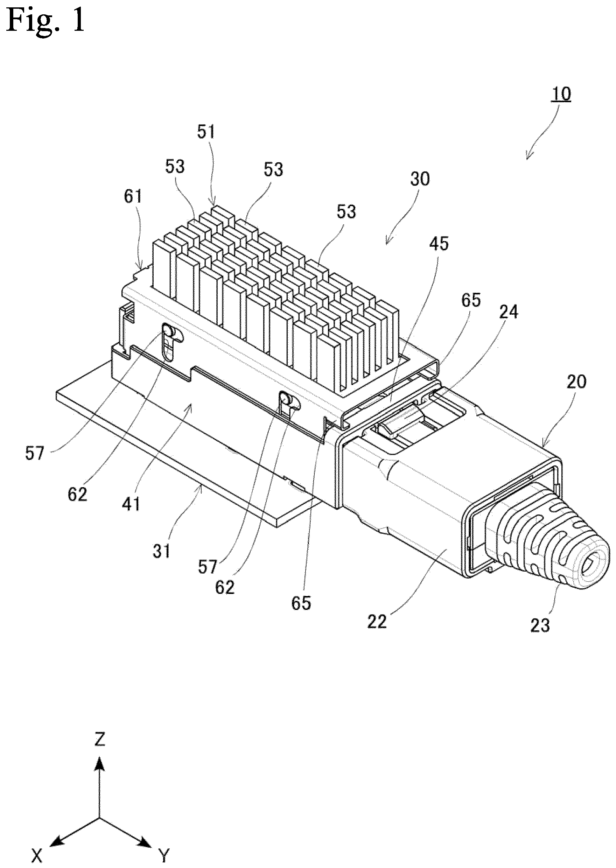

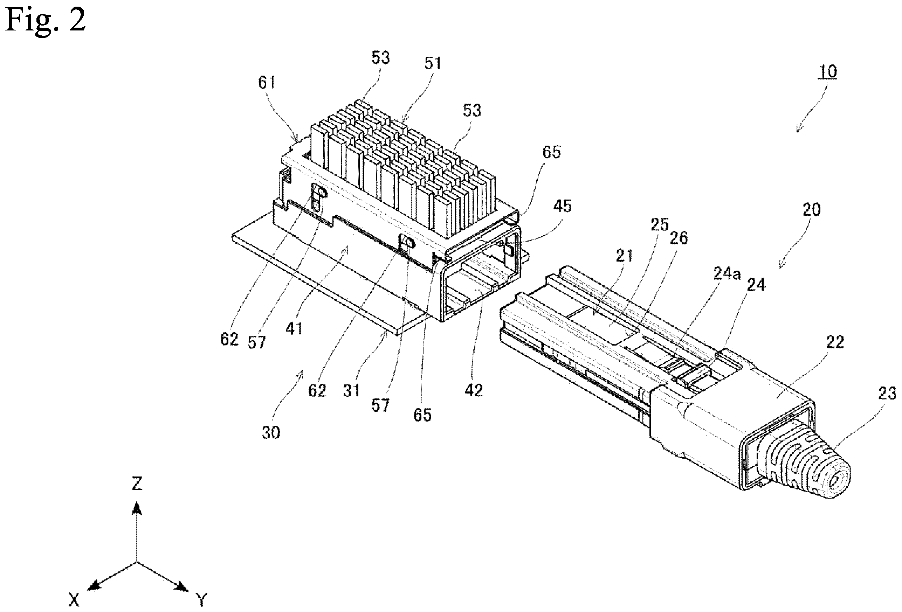

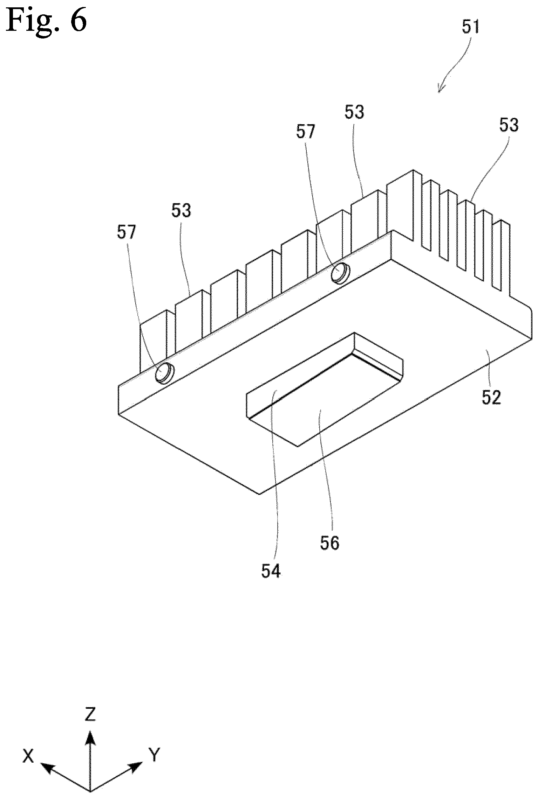

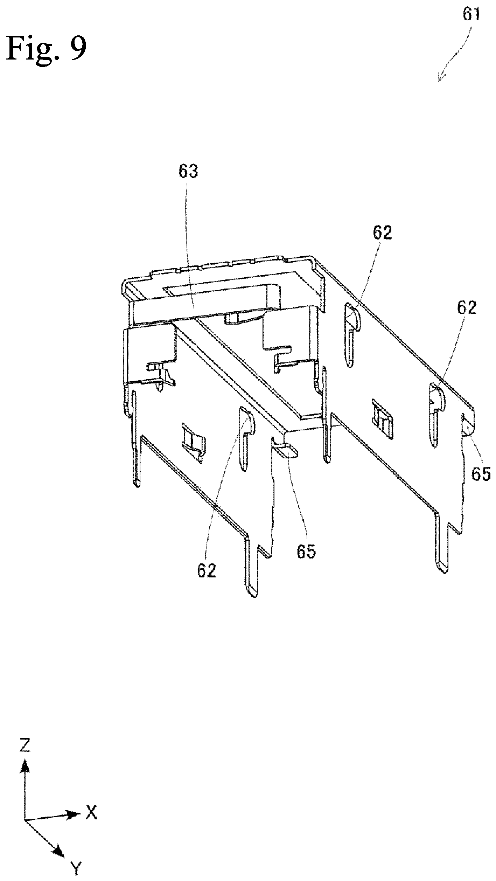

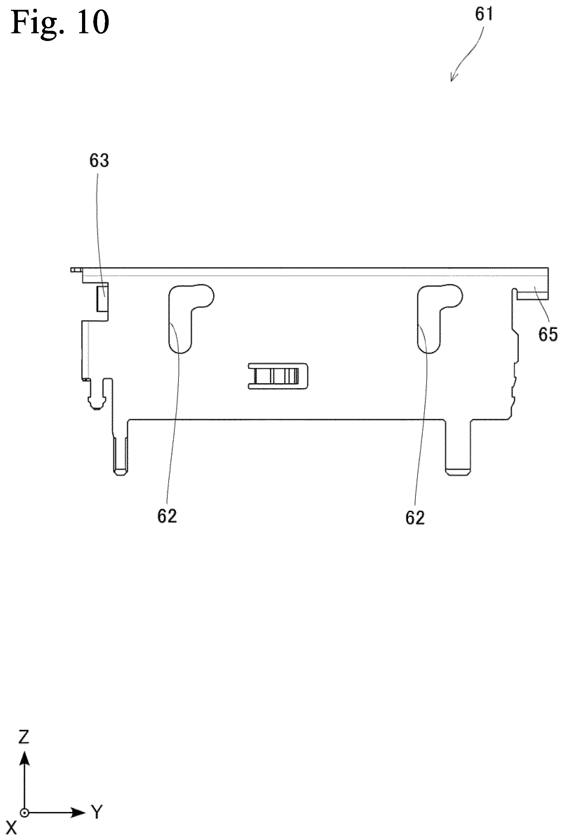

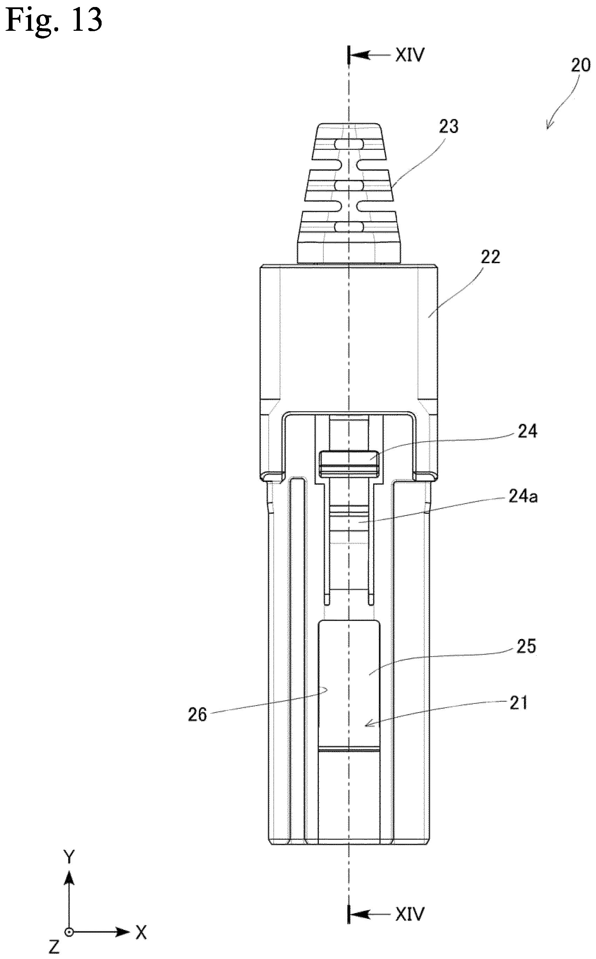

First, an entire configuration of the electronic device 10 according to the present embodiment is described with reference to FIG. 1 to FIG. 14 and FIG. 30. As illustrated in FIG. 1 and FIG. 2, the electronic device 10 according to the present embodiment includes the plug connector 20 and a receptacle connector 30. The plug connector 20 can be inserted into/extracted from the receptacle connector 30.

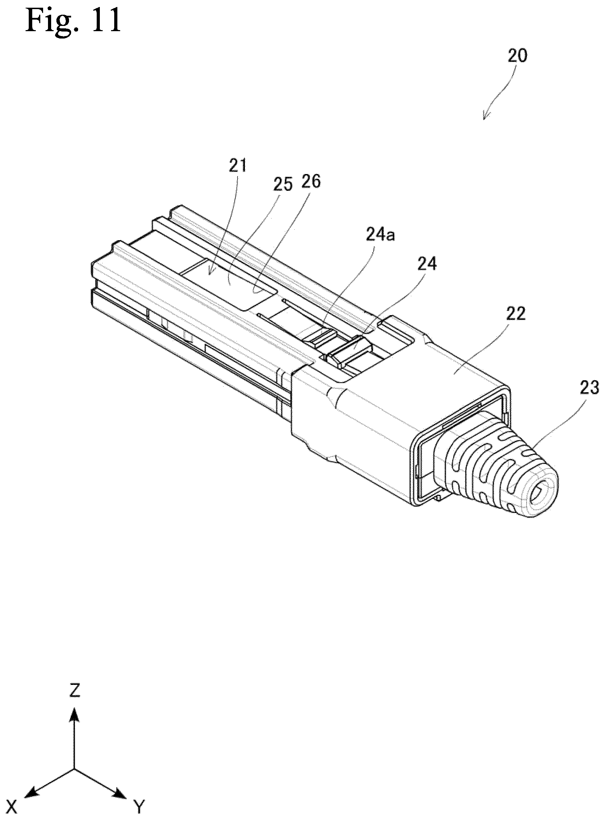

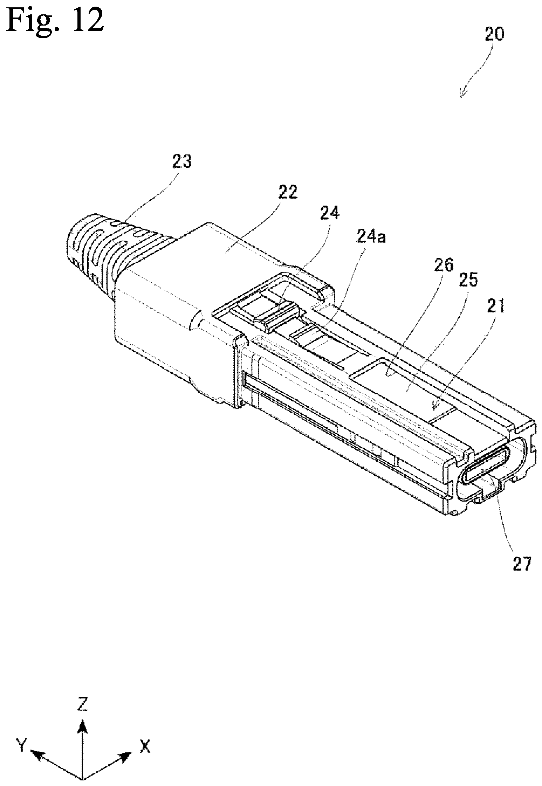

As illustrated in FIG. 11 to FIG. 14, the plug connector 20 includes the plug shell 21 and a plug housing 22. The plug shell 21 is made of a conductive metal material. In particular, as illustrated in FIG. 12, a plug-side fitting terminal 27 is disposed inside the plug shell 21. On the other hand, the plug housing 22 is made of a non-conductive material such as a resin and an elastomer, and is disposed to cover an outer periphery of the plug shell 21.

A cable attachment portion 23 to which cables such as electric cables and optical fibers are attached is provided on a front part of the plug housing 22. By installing unillustrated cables through the cable attachment portion 23 and connecting the cables to the plug-side fitting terminal 27, electric signals, power, optical information, and the like can be delivered.

Further, a locking portion 24 is provided on the plug housing 22. The locking portion 24 serves as fixing means for maintaining a fitted state of the receptacle housing 41 described below and the plug connector 20 when the plug connector 20 and the receptacle connector 30 are in a fitted state. The locking portion 24 according to the present embodiment has a double-end supported beam shape, and has a form including a claw 24a at a center part. Therefore, when the plug connector 20 is inserted into the receptacle housing 41 described below, the claw 24a at the center part is bent downward by coming into contact with a locked portion 45 provided as fixed means on the receptacle housing 41 described below. After the locking portion 24 climbs over the locked portion 45, the claw 24a returns to an original position and engages with the locked portion 45. In this manner, the function as the fixing means is exerted. In contrast, in the fitted state, the user presses the locking portion 24 downward from above in the -Z direction. As a result, the claw 24a at the center part is bent and moved downward, and disengages from the locked portion 45 of the receptacle housing 41 described below. Therefore, when the user extracts the plug connector 20 from the receptacle housing 41 described below in this state, the plug connector 20 can be released from the fitted state with the receptacle connector 30.

A plug opening 26 opening upward is provided on a rear upper side of the plug connector 20. The plug opening 26 exposes the plug shell 21 installed inside the plug housing 22 upward. An exposed portion of the plug shell 21 serves as the contact surface 25 of the plug shell 21. When a heat conductive sheet 56 installed on the heat releasing surface of the heat sink 51 described below comes into contact with the contact surface 25 on the upper surface of the plug shell 21 in a state where an upper part is exposed by the plug opening 26, the heat sink 51 can dissipate heat generated from the plug connector 20.

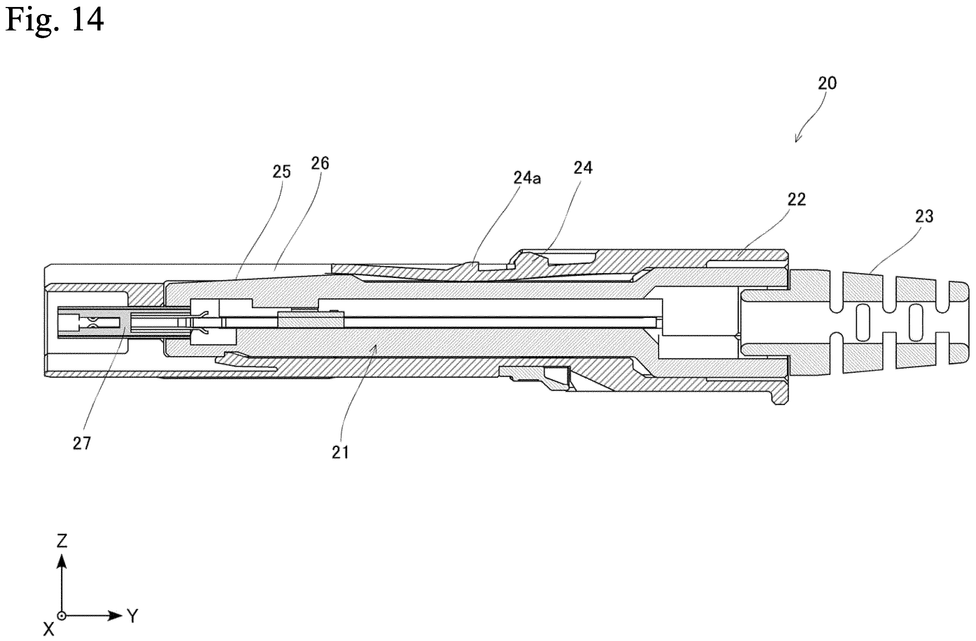

Further, as illustrated in FIG. 14, the contact surface 25 of the plug shell 21 is formed as an inclined surface having inclination to the front-rear direction ($\pm$Y direction) that is the first direction according to the present invention. In the present embodiment, the contact surface 25 of the plug shell 21 is formed as the inclined surface inclined downward as it goes in the rearward direction (in -Y direction).

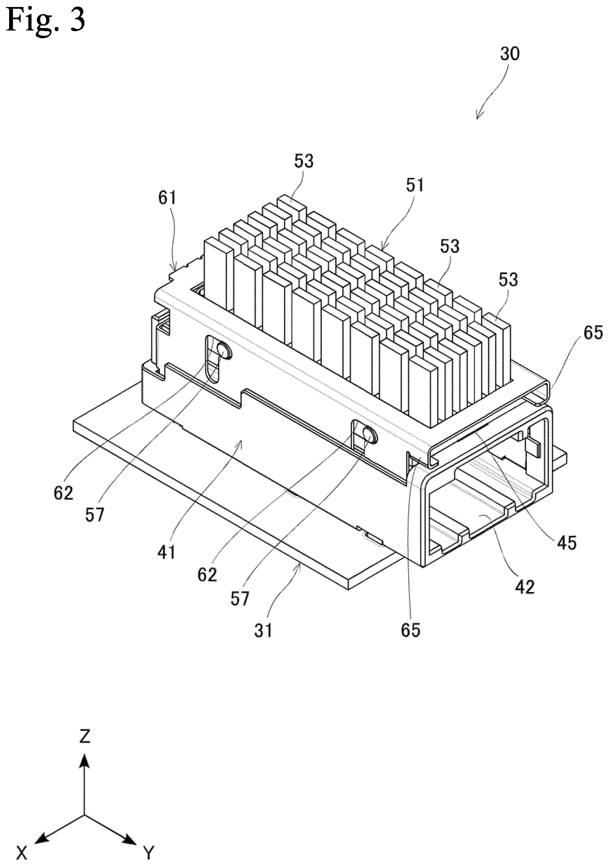

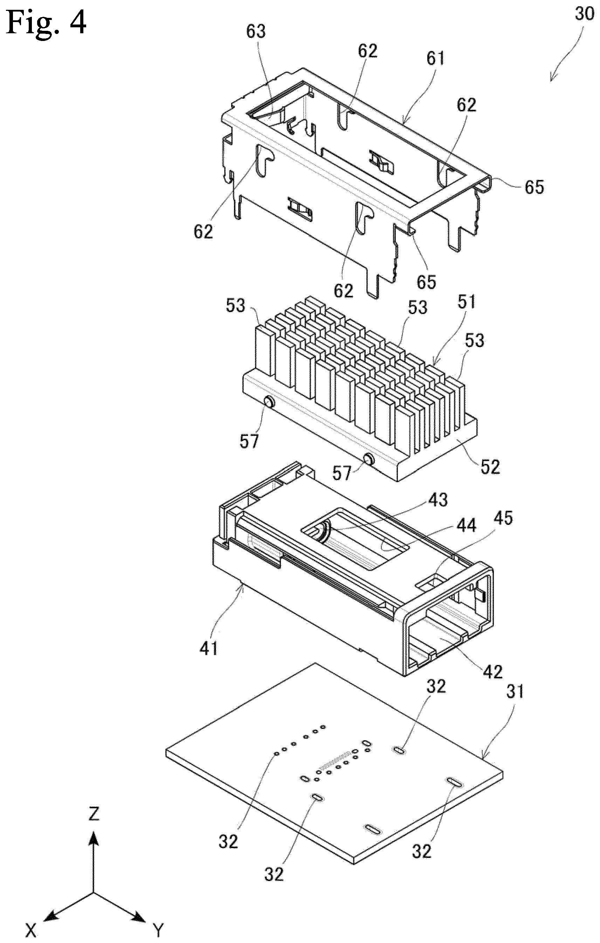

As illustrated in FIG. 3 and FIG. 4, the receptacle connector 30 includes a substrate 31, the receptacle housing 41, the heat sink 51, and a receptacle shell 61.

The substrate 31 includes an unillustrated printed circuit and the like. By electrically connecting the printed circuit to the receptacle housing 41 and the like attached to an upper surface of the substrate 31, electric signals, power, optical information, and the like can be delivered.

In particular, as illustrated in FIG. 4, the substrate 31 includes a plurality of attachment holes 32. Leg portions, terminals, and the like held by the receptacle housing 41 and the receptacle shell 61 are inserted into the plurality of attachment holes 32, and the receptacle housing 41 and the receptacle shell 61 are fixed to the substrate 31.

The receptacle housing 41 includes the opening 42 opening forward. The plug connector 20 is inserted into and extracted from the opening 42, which makes it possible to realize the fitted state and the non-fitted state of the plug connector 20 and the receptacle connector 30.

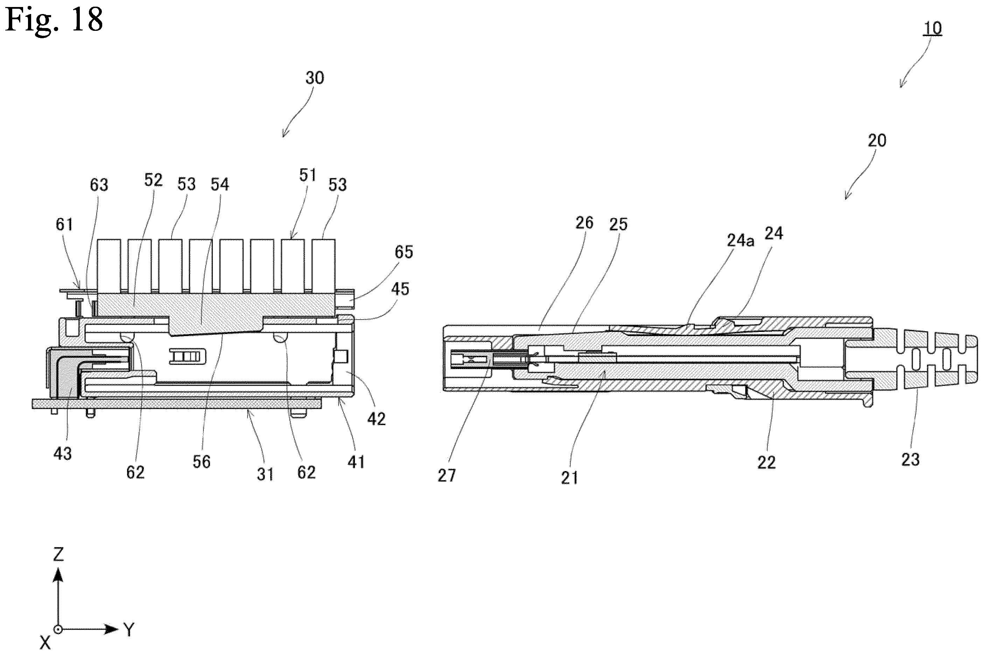

A receptacle-side fitting terminal 43 is disposed inside the receptacle housing 41. As illustrated in FIG. 18, FIG. 23 and FIG. 28, the receptacle-side fitting terminal 43 is mounted on the surface of the substrate 31 by soldering, and can be electrically connected to the substrate 31 including the unillustrated printed circuit and the like. When the plug connector 20 and the receptacle connector 30 are in the fitted state, the receptacle-side fitting terminal 43 and the plug-side fitting terminal 27 come into contact with each other. Therefore, electric signals, power, optical information, and the like from the unillustrated cables can be delivered to the substrate 31 through the plug connector 20 and the receptacle connector 30.

An upward open hole 44 opening upward is provided at an upper center part of the receptacle housing 41. The upward open hole 44 has an open hole shape such that the contact surface 25 of the plug shell 21 inserted into the opening 42 of the receptacle housing 41 and the heat releasing surface (heat conductive sheet 56) of the heat sink 51 described below face each other and come into contact with each other.

Further, as illustrated in FIG. 4, the locked portion 45 is provided at an upper front part of the receptacle housing 41. The locked portion 45 serves as the fixed means for engaging with the locking portion 24 held by the above-described plug connector 20. The locked portion 45 has a hole shape into which the claw 24a configuring the locking portion 24 is fitted, and a horizontal wall surface on a front side of the hole shape. Therefore, when the plug connector 20 is inserted into the receptacle housing 41, the claw 24a configuring the locking portion 24 is bent downward by coming into contact with the horizontal wall surface configuring the locked portion 45 of the receptacle housing 41. After the claw 24a climbs over the horizontal wall surface configuring the locked portion 45, the claw 24a returns to the original position and engages with the hole shape configuring the locked portion 45. In this manner, the function as the fixing means is exerted. In contrast, in the fitted state, the user presses the locking portion 24 downward from above in the -Z direction. As a result, the claw 24a is bent and moved downward, and disengages from the hole configuring the locked portion 45. Therefore, when the user extracts the plug connector 20 from the receptacle housing 41 in this state, the plug connector 20 can be released from the fitted state with the receptacle connector 30.

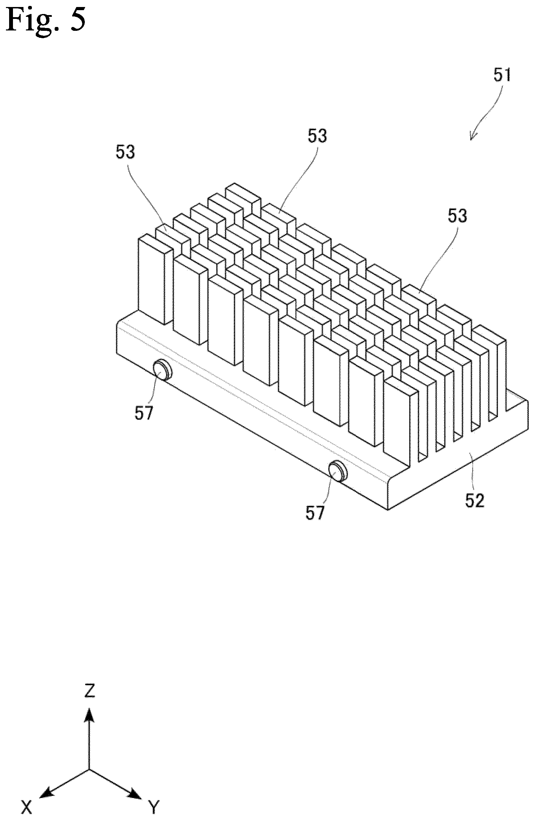

In particular, as illustrated in FIG. 5 to FIG. 7, the heat sink 51 includes a base portion 52 having a flat plate shape on a lower part, and a fin-shaped portion 53 formed as a plurality of walls standing upward from the base portion 52. The heat sink 51 is made of a metal material having high heat conductivity, for example, an aluminum alloy. The heat sink 51 has a large surface area because of presence of the fin-shaped portion 53 formed as the plurality of walls. Thus, the heat sink 51 is a member having high heat dissipation efficiency.

The plug shell 21 that is a heat dissipation target of the heat sink 51 is positioned below the heat sink 51. Therefore, a protruding portion 54 having a rectangular shape is provided on a lower surface of the base portion 52 configuring the heat sink 51. The heat conductive sheet 56 is installed on a lower surface of the protruding portion 54 because the lower surface of the protruding portion 54 serves as the heat releasing surface of the heat sink 51. By installing the heat conductive sheet 56 at a portion coming into contact with the plug shell 21 that is the heat dissipation target, heat resistance (difficulty of heat conduction) can be reduced, and higher heat dissipation effect can be achieved.

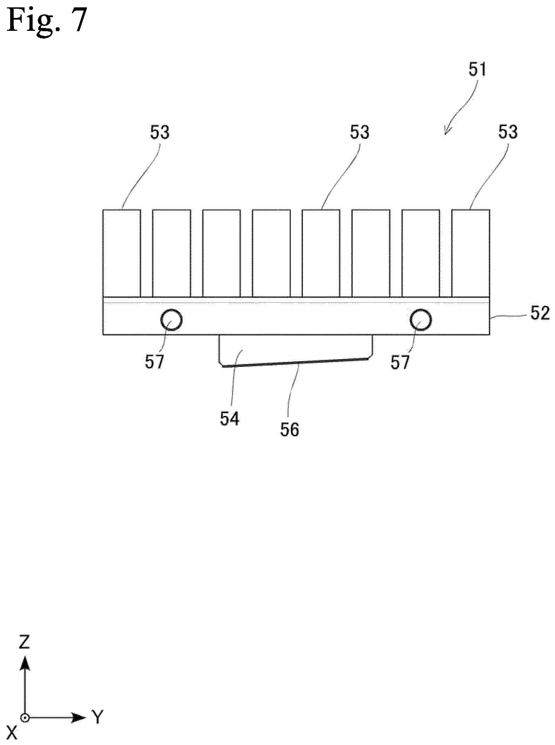

Further, a lower-side surface provided with the heat conductive sheet 56 serving as the heat releasing surface of the heat sink 51 is formed as an inclined surface having inclination to the front-rear direction (±Y direction) that is the first direction according to the present invention as illustrated in FIG. 7. In the present embodiment, the heat releasing surface configuring a lower surface of the protruding portion 54 of the heat sink 51 is formed as the inclined surface inclined downward as it goes in the rearward direction (in -Y direction). The heat releasing surface of the heat sink 51 and the contact surface 25 of the plug shell 21 described above are inclined surfaces disposed to face each other in the fitted state, and have a substantially same inclination angle. Therefore, in the fitted state where the plug connector 20 is inserted into the opening 42 of the receptacle housing 41, the heat releasing surface (heat conductive sheet 56) of the heat sink 51 and the contact surface 25 of the plug shell 21 come into contact with each other without a gap.

Further, four columnar protrusions 57 protruding in the left-right direction are provided on left and right side surfaces of the base portion 52 of the heat sink 51. The four columnar protrusions 57 are formed as guided portions according to the present invention. The four columnar protrusions 57 are members to be fitted into cam grooves 62 that are guide portions according to the present invention provided in the receptacle shell 61 described below.

The receptacle shell 61 is a member for movably installing the heat sink 51 on the receptacle housing 41. The receptacle shell 61 includes two cam grooves 62 on left and right side surfaces, namely, four cam grooves 62 in total. The four cam grooves 62 are formed as the guide portions according to the present invention. When the four columnar protrusions 57 held by the heat sink 51 are fitted into the four cam grooves 62, the heat sink 51 is movably supported to the receptacle shell 61 within formation ranges of the four cam grooves 62. Each of the four cam grooves 62 has a substantially L-shaped groove shape.

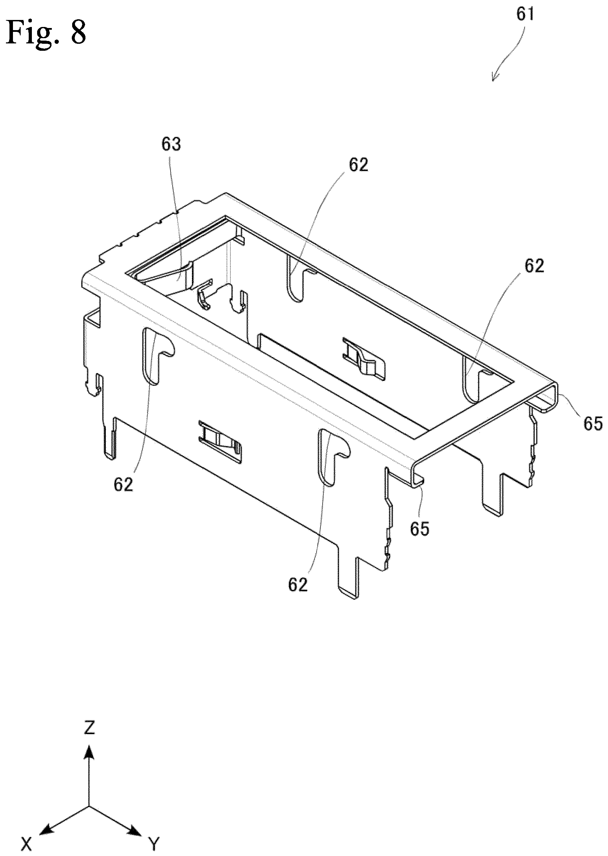

As illustrated in FIG. 8 to FIG. 10, the receptacle shell 61 includes pressing means 63. The pressing means 63 presses the heat sink 51 attached using the cam grooves 62 in the forward direction (in +Y direction) that is a positive first direction, relative to the receptacle shell 61. In the present embodiment, the pressing means 63 is formed as a cantilever spring having a cantilever shape configured as a member integrated with the receptacle shell 61.

As illustrated in FIG. 8 to FIG. 10, the receptacle shell 61 includes stopper portions 65. When the heat sink 51 attached using the cam grooves 62 is pressed in the forward direction (in +Y direction) that is the positive first direction by pressing force of the pressing means 63, the stopper portions 65 come into contact with the heat sink 51 to define a stop position of the heat sink 51. The stopper portions 65 define a moving range limit of the heat sink 51 pressed by the pressing means 63 in the forward direction (in +Y direction) that is the positive first direction.

Since the receptacle shell 61 according to the present embodiment has the above-described configuration, the receptacle connector 30 is completed by inserting the receptacle shell 61 into the receptacle housing 41 downward from above (in -Z direction) in the state where the heat sink 51 is attached using the cam grooves 62.

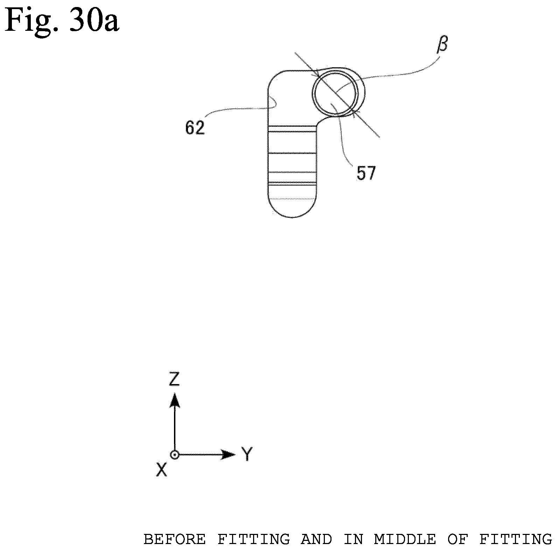

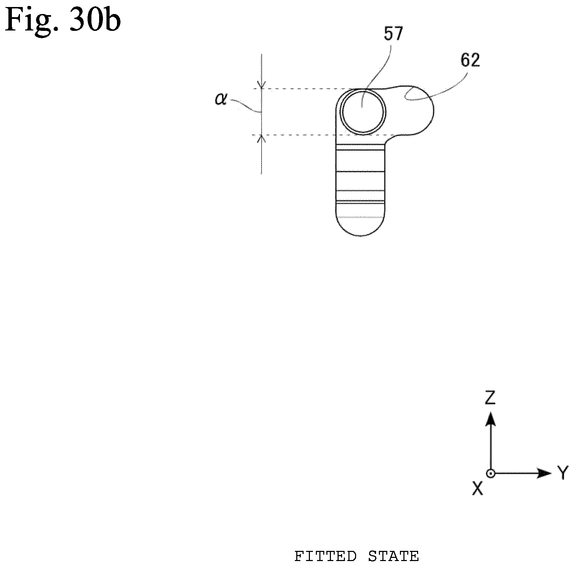

Dimensional conditions of the cam grooves 62 provided in the receptacle shell 61 and the columnar protrusions 57 fitted into the respective cam grooves 62 are described with reference to FIG. 30. In the present embodiment, the cam grooves 62 provided in the receptacle shell 61 and the columnar protrusions 57 fitted into the respective cam grooves 62 are configured so as to establish the following expression,

$$\alpha \approx \beta,$$

where $\alpha$ is a second-direction dimension between a negative-second-direction part (lower part) of each cam groove 62 on the positive first direction side (on forward direction (+Y direction) side) and a positive-second-direction part (upper part) of the cam groove 62 on the negative first direction side (on rearward direction (-Y direction) side), and $\beta$ is a second-direction dimension (dimension in up-down direction (±Z direction)) that is a diameter dimension of each columnar protrusion 57. Therefore, when the heat sink 51 is positioned in the positive first direction (in forward direction (in +Y direction)) relative to the receptacle shell 61, the cam grooves 62 provided in the receptacle shell 61 exert a function of regulating movement of the heat sink 51 in the negative second direction (in downward direction (in -Z direction)). When the heat sink 51 is positioned in the negative first direction (in rearward direction (in -Y direction)) relative to the receptacle shell 61, the cam grooves 62 exert a function of regulating movement of the heat sink 51 in the positive second direction (in upward direction (in +Z direction)). In other words, in the present embodiment, the heat sink 51 supported to be movable in the first direction (in front-rear direction (in ±Y direction)) relative to the receptacle shell 61 is configured to move in a direction parallel to the first direction (front-rear direction (±Y direction)).

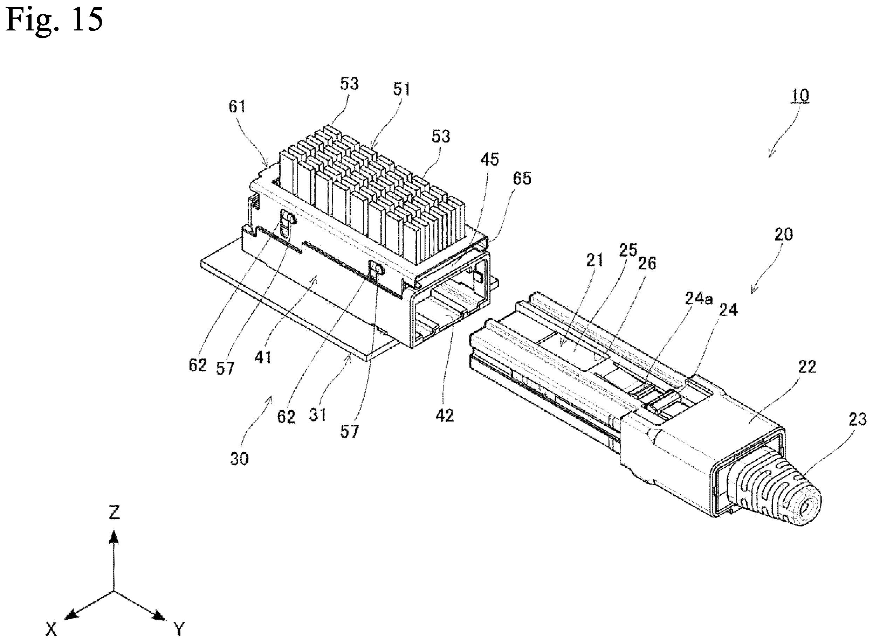

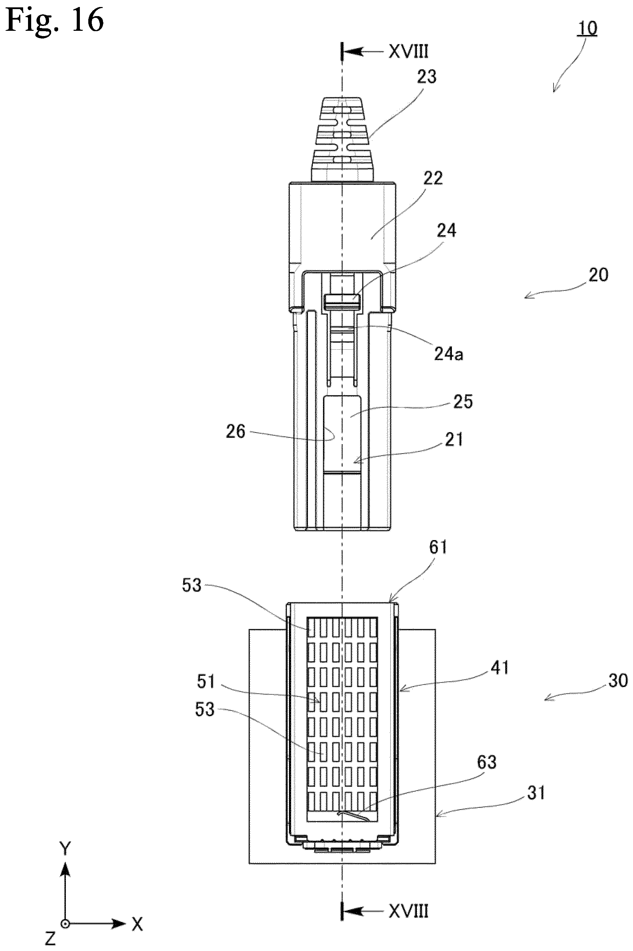

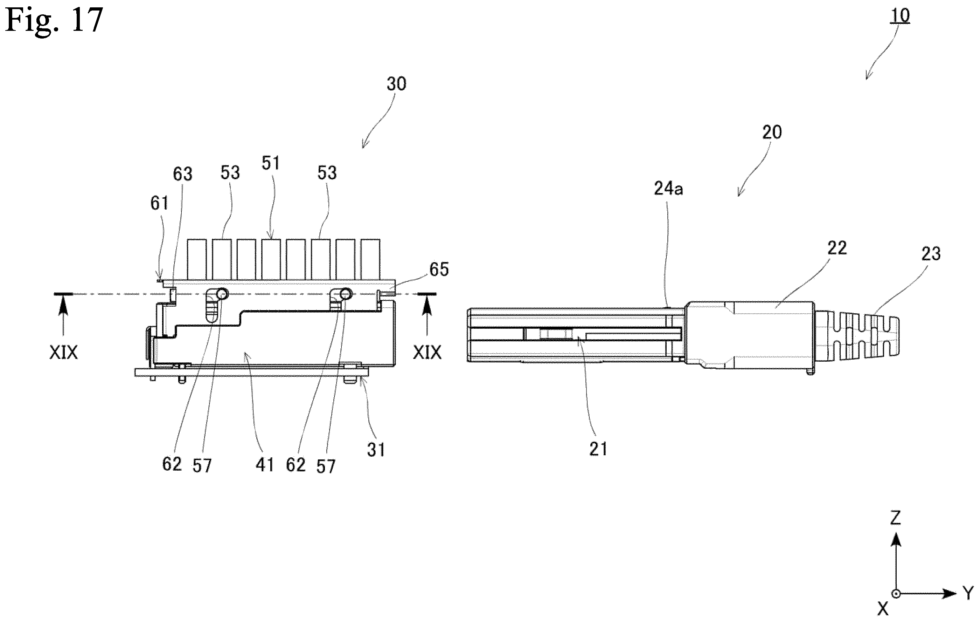

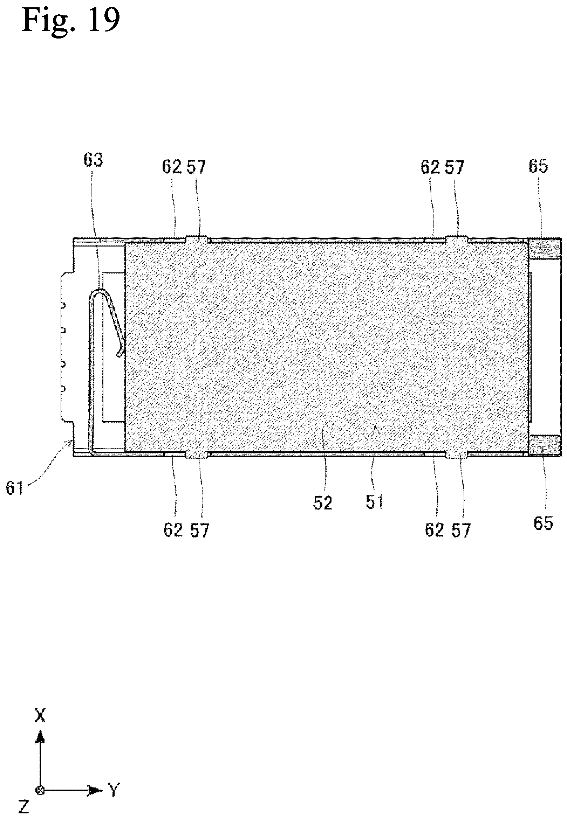

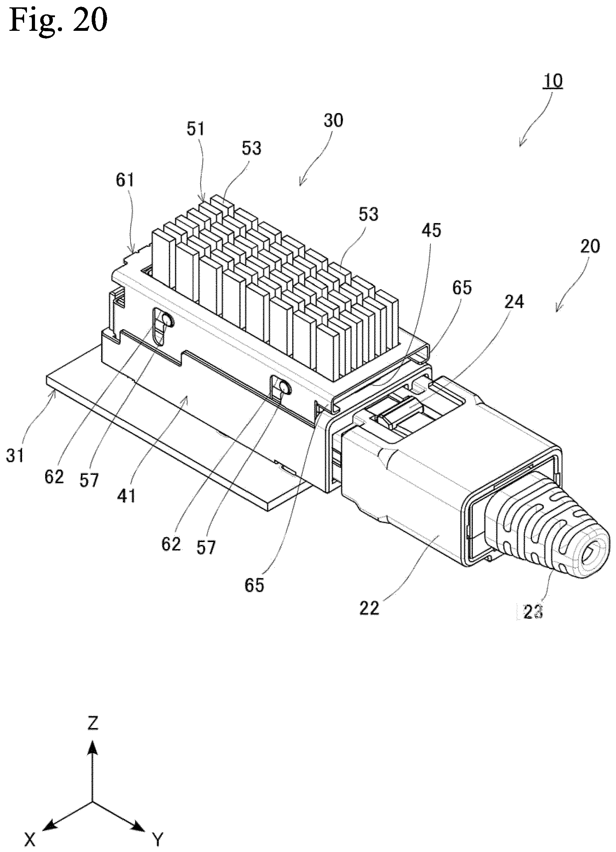

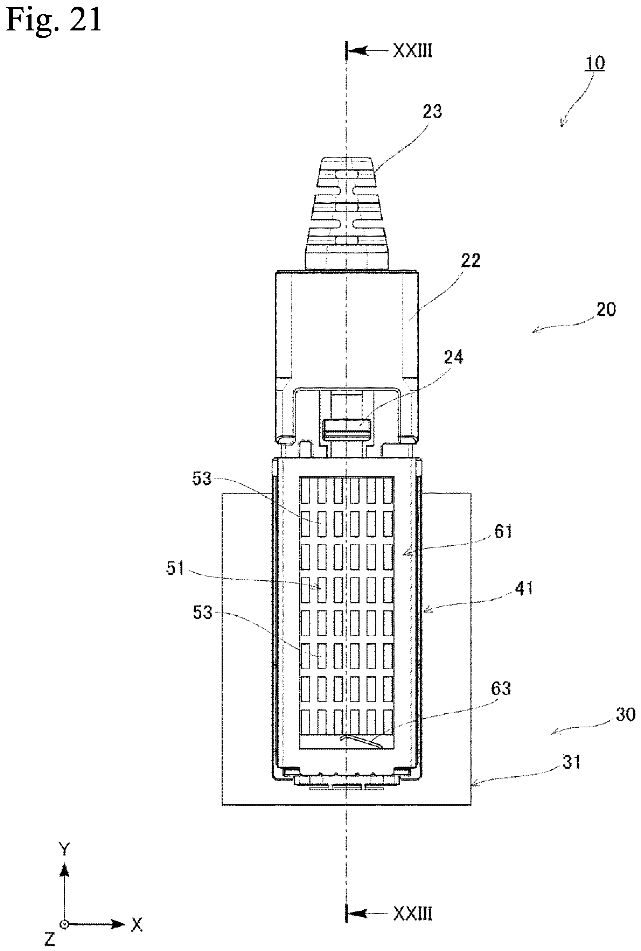

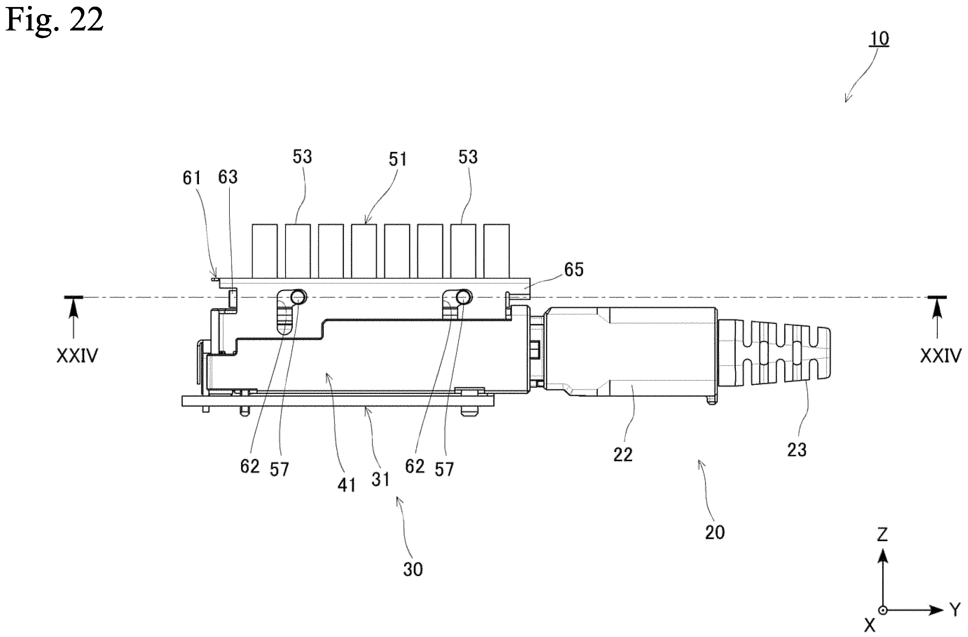

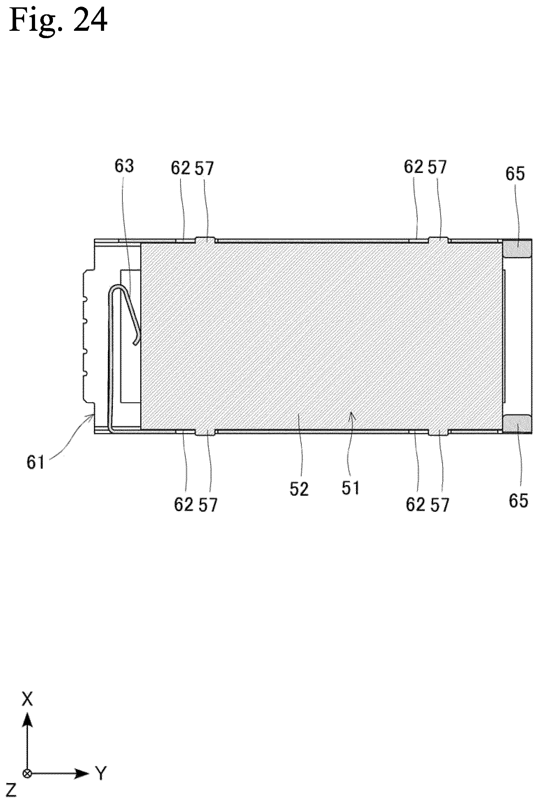

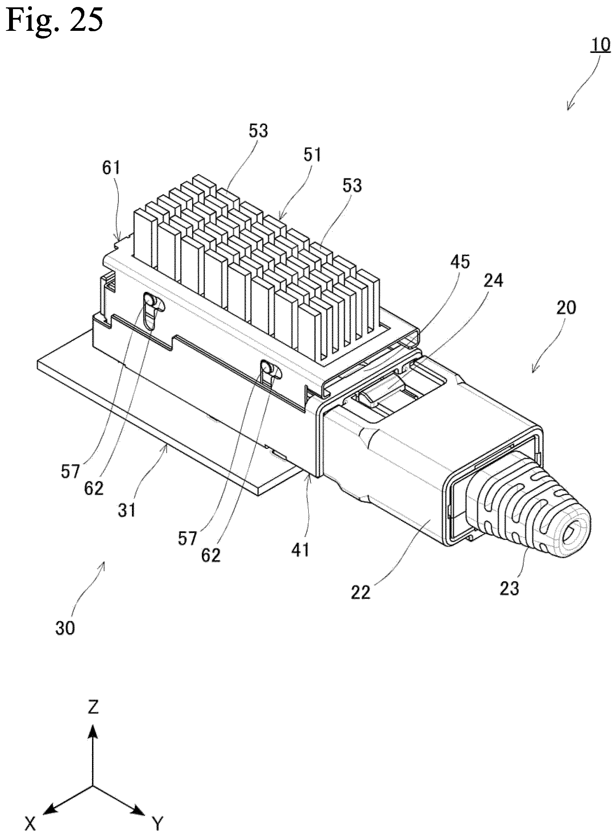

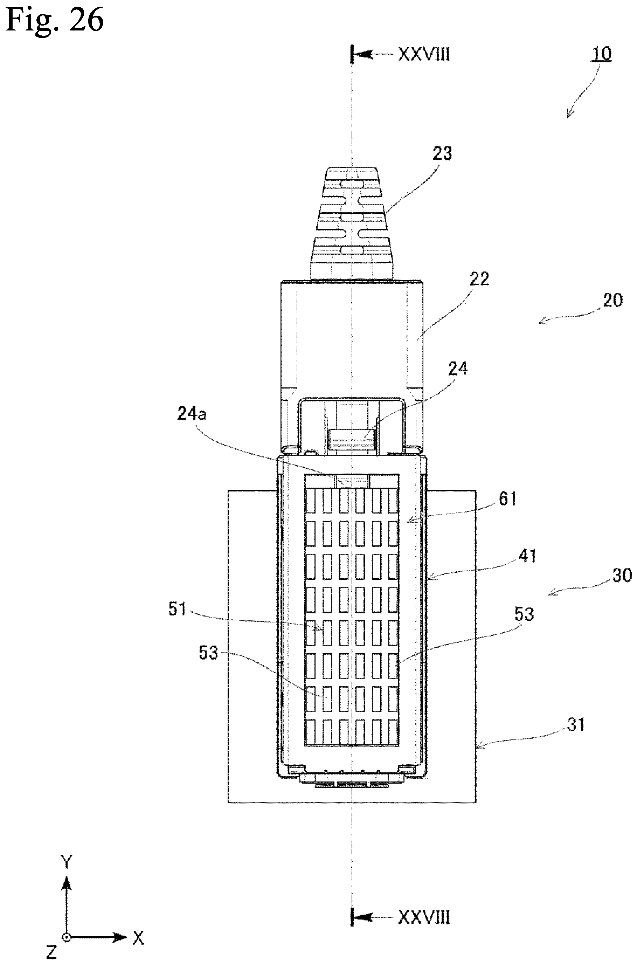

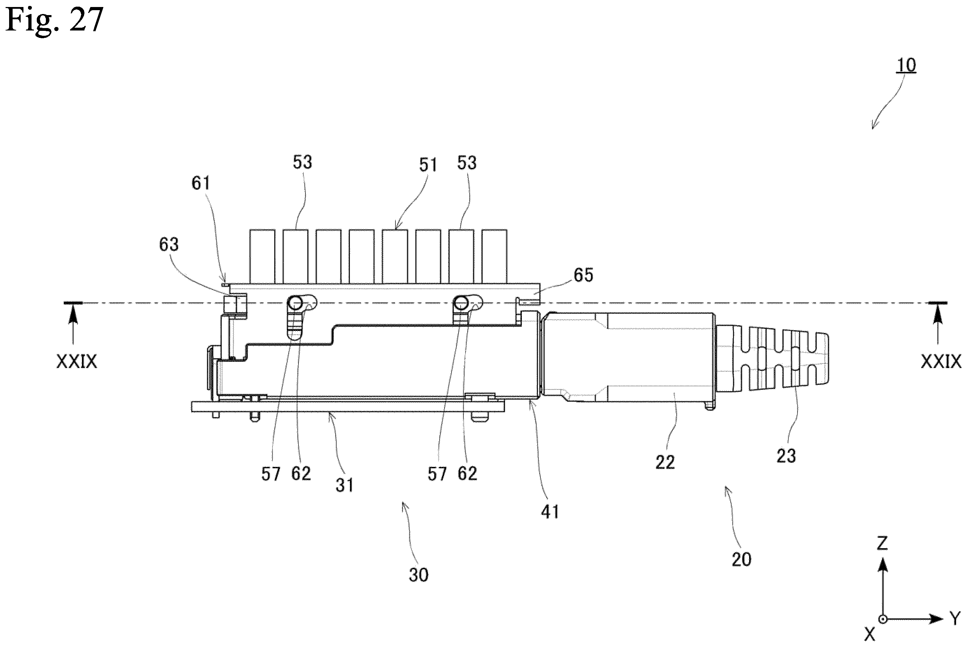

The entire configuration of the electronic device 10 according to the present embodiment is described above with reference to FIG. 1 to FIG. 14, and FIG. 30. Next, specific operation of the electronic device 10 according to the present embodiment is described with additional reference to FIG. 15 to FIG. 29. FIG. 15 to FIG. 19 illustrate a non-fitted state where the plug connector 20 is not inserted into the opening 42 of the receptacle housing 41. FIG. 20 to FIG. 24 illustrate a halfway fitted state where the plug connector 20 is being inserted into the opening 42 of the receptacle housing 41. FIG. 25 to FIG. 29 illustrate a fitted state where the plug connector 20 is completely inserted into the opening 42 of the receptacle housing 41. FIG. 30 illustrates positional relationship of one columnar protrusion 57 to the corresponding cam groove 62.

In the non-fitted state where the plug connector 20 is not inserted into the opening 42 of the receptacle housing 41 illustrated in FIG. 15 to FIG. 19, in particular, as illustrated in FIG. 18, the heat sink 51 is pressed in the forward direction (in +Y direction) that is the first direction, by the pressing means 63 provided on the receptacle shell 61. At this time, a front part of the heat sink 51 abuts on the stopper portions 65. The columnar protrusions 57 provided on the left and right side surfaces of the heat sink 51 are fitted to the respective cam grooves 62 provided in the receptacle shell 61; however, in the non-fitted state, lower parts (-Z-direction parts) of the columnar protrusions 57 enter grooves on the positive first direction side (forward direction (+Y direction) side) of the respective cam grooves 62 provided in the receptacle shell 61, and the heat sink 51 is regulated so as not to move in the downward direction (in -Z direction) beyond a predetermined up-down position (Z-direction position).

As illustrated in FIG. 18, the heat sink 51 includes the protruding portion 54 on the lower surface, and the heat conductive sheet 56 is installed on the heat releasing surface configuring the lower surface of the protruding portion 54. The heat conductive sheet 56 configuring the heat releasing surface according to the present invention is formed as the inclined surface inclined downward as it goes in the rearward direction (in -Y direction). On the other hand, in the plug connector 20, the contact surface 25 of the plug shell 21 is exposed upward such that the heat conductive sheet 56 can come into contact with the contact surface 25. The contact surface 25 of the plug shell 21 is also inclined as with the heat releasing surface (heat conductive sheet 56) of the heat sink 51. Since the heat releasing surface (heat conductive sheet 56) of the heat sink 51 and the contact surface 25 of the plug shell 21 and are formed as the inclined surfaces that have the substantially same inclination angle and are disposed to face each other in the fitted state, both inclined surfaces can come into contact with each other without a gap.

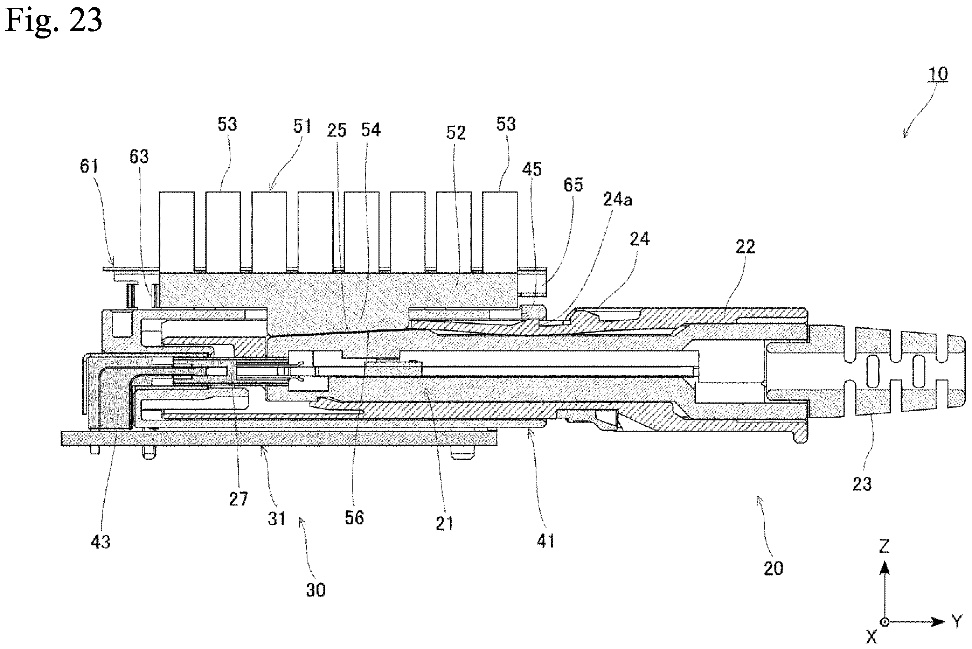

FIG. 20 to FIG. 24 illustrate the halfway fitted state where the plug connector 20 is being inserted into the opening 42 of the receptacle housing 41 from the non-fitted state. In particular, FIG. 23 illustrates, as a halfway fitted state, a state where the contact surface 25 of the plug shell 21 and the heat conductive sheet 56 serving as the heat releasing surface of the heat sink 51 abut on each other for the first time in the middle of insertion of the plug connector 20 into the opening 42 of the receptacle housing 41. In this state, the heat sink 51 is at the position same as the position in the non-fitted state. In the state illustrated in FIG. 23, the locking portion 24 held by the plug connector 20 comes into contact with the horizontal wall surface configuring the locked portion 45, the claw 24a is bent downward, and the locking portion 24 and the locked portion 45 do not yet engage with each other.

When the fitting further progresses from the halfway fitted state, the plug connector 20 is completely inserted into the opening 42 of the receptacle housing 41 to establish the fitted state. FIG. 25 to FIG. 29 illustrate the fitted state. When the fitting further progresses from the above-described halfway fitted state, the plug connector 20 and the heat sink 51 move in the rearward direction (in -Y direction) while the state where the heat conductive sheet 56 serving as the heat releasing surface of the heat sink 51 and the contact surface 25 of the plug shell 21 are in contact with each other is maintained.

At this time, although the columnar protrusions 57 of the heat sink 51 move inside the respective cam grooves 62 in the rearward direction (in -Y direction), immediately after the columnar protrusions 57 start movement, movement in the upward direction (in +Z direction) of the columnar protrusions 57 is regulated by the cam grooves 62, and the heat sink 51 parallelly moves in the rearward direction (in -Y direction) together with the plug connector 20. The moving mechanism is realized by making the up-down-direction dimension ($\pm$Z-direction dimension) $\alpha$ between the lower part (-Z-direction part) of each cam groove 62 on the forward direction side (+Y direction side) and the upper part (+Z-direction part) of the cam groove 62 on the rearward direction side (-Y direction side), substantially coincident with the diameter dimension $\beta$ of each columnar protrusion 57 ($\alpha \approx \beta$ is established) as illustrated in FIG. 30.

Further, when the fitting further progresses from the above-described halfway fitted state, a load in the forward direction (in +Y direction) applied to the heat sink 51 from the pressing means 63 is increased based on a moving amount of the heat sink 51 in the rearward direction (in -Y direction). When the load from the pressing means 63, force in the downward direction (in -Z direction) received by the columnar protrusions 57 of the heat sink 51 from the cam grooves 62, and the force received by the heat releasing surface (heat conductive sheet 56) of the heat sink 51 from the contact surface 25 of the plug shell 21 are balanced, contact of the heat conductive sheet 56 and the plug shell 21 is maintained.

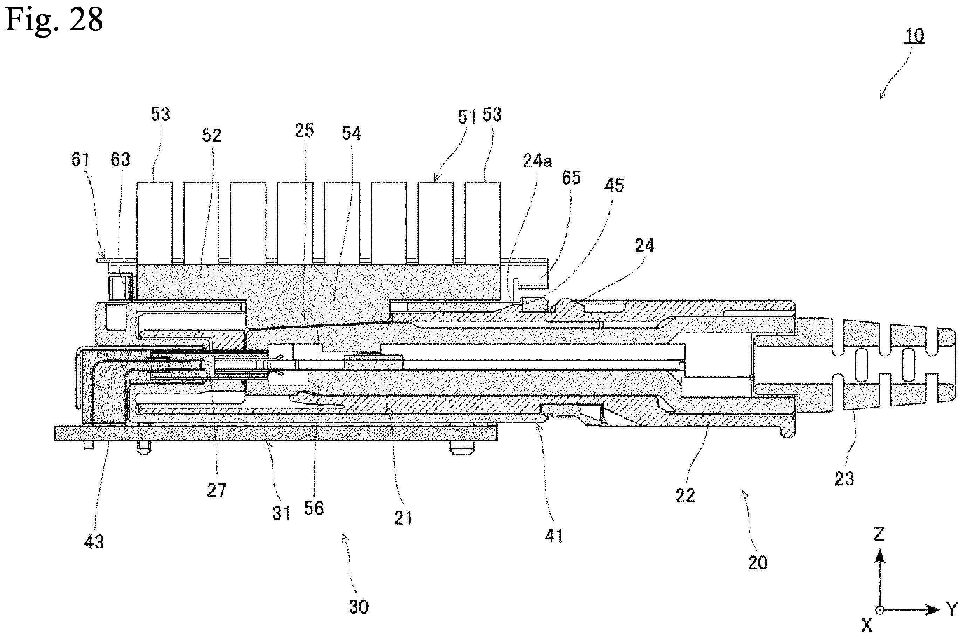

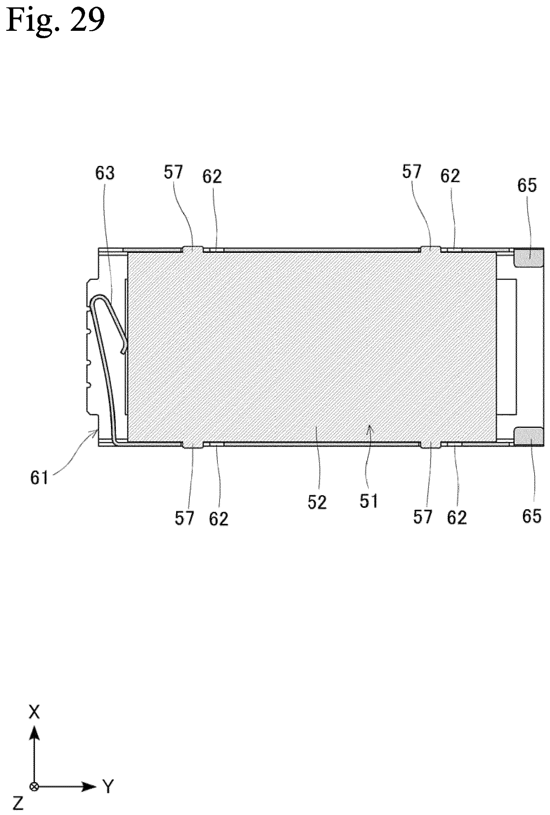

In the fitted state, as illustrated in FIG. 29, the heat sink 51 bends the pressing means 63. Thus, force acts on the plug connector 20 in a separation direction that is the forward direction (+Y direction). However, as illustrated in FIG. 28, the locking portion 24 and the hole shape configuring the locked portion 45 engage with each other. Therefore, the force in the separation direction acting on the plug connector 20 is received by the locking portion 24 and the locked portion 45, and the fitted state is accordingly maintained.

In the electronic device of such a type, a fitting depth is inevitably varied due to variation in dimension of each of the members including the locking portion 24 and the like. If the heat sink 51 is fixed to the receptacle shell 61 and cannot move in the front-rear direction and the up-down direction (in YZ directions), each of the members is hardly elastically displaced. Therefore, contact force of the heat conductive sheet 56 and the plug shell 21 is largely varied due to variation of the fitting depth.

However, in the electronic device 10 according to the present embodiment, the heat sink 51 is movable in the front-rear direction (in $\pm$Y direction) together with the plug connector 20. Therefore, the cantilever spring of the pressing means 63 is elastically displaced, which makes it possible to reduce variation in contact force of the heat conductive sheet 56 and the plug shell 21 caused by the above-described variation.

Further, since the heat sink 51 and the plug connector 20 parallelly move together in the front-rear direction (in $\pm$Y direction) from the halfway fitted state to the fitted state, the heat conductive sheet 56 and the plug shell 21 can be brought into contact with each other without sliding on each other.

By performing operation as described above, the fitted state where the plug connector 20 is completely inserted into the opening 42 of the receptacle housing 41 as illustrated in FIG. 25 to FIG. 29 is realized.

Each of the cam grooves 62 according to the present embodiment has a substantially L-shaped groove shape. Although the groove shape of the lower part (-Z direction) of each of the cam grooves 62 has a length more than necessary, the shape is adopted to facilitate assembly of the heat sink 51 to the receptacle shell 61.

The operation when the plug connector 20 is inserted into the opening 42 of the receptacle housing 41 is described above. Next, separation operation when the plug connector 20 is extracted from the opening 42 of the receptacle housing 41 is described.

In the separation operation, the user presses the locking portion 24 downward from above in the downward direction (-Z direction). As a result, the claw 24a is bent and moved downward, and the locking portion 24 and the locked portion 45 disengage from each other. When the user extracts the plug connector 20 in the forward direction (in +Y direction) while maintaining the state, the separation operation can be performed. At this time, the pressing means 63 presses the heat sink 51 in the forward direction (in +Y direction), and the columnar protrusions 57 of the heat sink 51 move inside the respective cam grooves 62 in the forward direction (in +Y direction). As a result, the heat sink 51 is returned to the halfway fitted state. Even in the separation operation, since the heat sink 51 and the plug connector 20 both move in the forward direction (in +Y direction) while the heat conductive sheet 56 serving as the heat releasing surface and the contact surface 25 of the plug shell 21 are in contact with each other, the separation operation can be competed while the heat conductive sheet 56 and the plug shell 21 hardly slide on each other.

In the electronic device 10 according to the present embodiment described above, when the plug connector 20 is inserted into the opening 42 of the receptacle housing 41 and the fitted state is established, the contact surface 25 of the plug shell 21 and the heat releasing surface (heat conductive sheet 56) of the heat sink 51 come into contact with each other without rubbing each other, which enables the heat sink 51 to efficiently dissipate heat generated from the plug connector 20. Further, according to the present embodiment, the mechanism for enabling the heat sink 51 to efficiently dissipate heat generated from the plug connector 20 can be realized with a simple configuration.

Although the preferred embodiment of the present invention is described above, the technical scope of the present invention is not limited to the scope described in the above-described embodiment. Various changes or improvements can be added to the above-described embodiment.

For example, in the above-described present embodiment, the pressing means 63 is a cantilever spring having a cantilever shape formed on the receptacle shell 61. However, the pressing means according to the present invention can be formed as a double-end supported spring having a double-end supported beam shape.

For example, in the above-described embodiment, the pressing means 63 is configured as the members integrated with the receptacle shell 61. However, the pressing means according to the present invention can be configured as members separated from the receptacle shell. More specifically, the pressing means according to the present invention are formed as coil springs or plate springs separated from the receptacle shell 61, and are installed between the receptacle shell 61 and the heat sink 51. This makes it possible to realize an electronic device that can achieve action effects similar to the action effects by the above-described present embodiment.

For example, in the above-described present embodiment, the configuration in the case where the heat conductive sheet 56 is installed on the heat releasing surface of the heat sink 51 abutting on the contact surface 25 of the plug shell 21 is exemplified; however, installation of the heat conductive sheet 56 can be omitted in the electronic device according to the present invention.

For example, in the above-described embodiment, the form example in the case where the guide portions provided in the receptacle shell 61 are formed as the cam grooves 62 each having a groove shape, and the guided portions provided on the heat sink 51 are formed as the columnar protrusions 57 fitted to the groove shapes of the respective cam grooves 62 is illustrated. However, as the guide portions and the guided portions according to the present invention, all forms can be adopted as long as action effects similar to the action effects by the above-described embodiment can be achieved.

Further, for example, in the above-described present embodiment, the electronic device 10 is described as an optical transceiver; however, the embodiment is merely a possible form of the electronic device according to the present invention. The electronic device according to the present invention can be applied to all types of electronic devices as long as action effects similar to the action effects achieved by the above-described present embodiment can be achieved.

It is also apparent from the claims that a form to which such changes or improvements are added can be included in the technical scope of the present invention.

Reference Signs List

| 10 | electronic device |
|---|---|
| 20 | plug connector |
| 21 | plug shell |
| 22 | plug housing |
| 23 | cable attachment portion |
| 24 | locking portion (fixing means) |
| 24a | claw |
| 25 | contact surface |
| 26 | plug opening |
| 27 | plug-side fitting terminal |
| 30 | receptacle connector |
| 31 | substrate |
| 32 | attachment hole |
| 41 | receptacle housing |
| 42 | opening |
| 43 | receptacle-side fitting terminal |
| 44 | upward open hole |
| 45 | locked portion (fixed means including horizontal |
| wall | surface and hole shape) |
| 51 | heat sink |
| 52 | base portion |
| 53 | fin-shaped portion |
| 54 | protruding portion |
| 56 | heat conductive sheet (heat releasing surface) |
| 57 | columnar protrusion (guided portion) |
| 61 | receptacle shell |
| 62 | cam groove (guide portion) |
| 63 | pressing means (cantilever spring having cantilever shape) |
| 65 | stopper portion |

**Claims**

1. An electronic device (10), comprising:

   a plug connector (20) including a plug shell (21) and a plug housing (22);
   a receptacle housing (41) including an opening (42) into/from which the plug connector (20) is insertable/extractable; and
   a heat sink (51) movably installed on the receptacle housing (41) by being installed through a receptacle shell (61) attached to the receptacle housing (41), wherein
   when the plug connector (20) is inserted into the opening (42) of the receptacle housing (41) and a fitted state is established, a contact surface (25) of the plug shell (21) and a heat releasing surface of the heat sink (51) come into contact with each other, and the heat sink (51) dissipates heat generated from the plug connector (20),
   when an insertion/extraction direction of the plug connector (20) into/from the opening (42) of the receptacle housing (41) is defined as a first direction, the extraction direction of the plug connector (20) from the opening (42) is defined as a positive first direction, the insertion direction is defined as a negative first direction, a direction orthogonal to the first direction is defined as a second direction, a direction in which the heat releasing surface of the heat sink (51) is disposed relative to the plug shell (21) in the fitted state is defined as a positive second direction, and a direction in which the plug shell (21) is disposed relative to the heat releasing surface of the heat sink (51) is defined as a negative second direction,
   the heat sink (51) is supported to be movable in the first direction relative to the receptacle shell (61),
   the contact surface (25) of the plug shell (21) and the heat releasing surface of the heat sink (51) are formed as inclined surfaces having inclination to the first direction,
   pressing means (63) configured to press the heat sink (51) in the positive first direction relative to the receptacle shell (61) is disposed between the heat sink (51) and the receptacle shell (61),
   the receptacle shell (61) includes a guide portion (62) configured to regulate movement of the heat sink (51) in the negative second direction when the heat sink (51) is at a position in the positive first direction relative to the receptacle shell (61), and to regulate movement of the heat sink (51) in the positive second direction when the heat sink (51) is at a position in the negative first direction relative to the receptacle shell (61), and

   the heat sink (51) includes a guided portion (57) configured to be guided by the guide portion (62) provided on the receptacle shell (61).

2. The electronic device (10) according to claim 1, wherein

   the guide portion (62) is formed as a cam groove having a groove shape,
   the guided portion (57) is formed as a columnar protrusion to be fitted into the groove shape of the cam groove, and
   an expression of $\alpha \approx \beta$ is established, where $\alpha$ is a second-direction dimension between a negative-second-direction part of the cam groove on the positive first direction side and a positive-second-direction part of the cam groove on the negative first direction side, and $\beta$ is a second-direction dimension that is a diameter dimension of the columnar protrusion.

3. The electronic device (10) according to claim 2, wherein the guide portion (62) formed as the cam groove has a substantially L-shaped groove shape.

4. The electronic device (10) according to any one of claims 1 to 3, wherein

   the plug housing (22) includes a locking portion (24) serving as fixing means,
   the receptacle housing (41) includes a locked portion (45) serving as fixed means, and
   when the plug connector (20) is inserted into the opening (42) of the receptacle housing (41) and the fitted state is established, the locking portion (24) and the locked portion (45) engage with each other to maintain the fitted state of the plug connector (20) to the receptacle housing (41) against pressing force by the pressing means (63).

5. The electronic device (10) according to any one of claims 1 to 4, wherein the pressing means (63) is configured as a member integrated with the receptacle shell (61).

6. The electronic device (10) according to any one of claims 1 to 4, wherein the pressing means (63) is configured as a member separated from the receptacle shell (61).

7. The electronic device (10) according to any one of claims 1 to 6, wherein the pressing means (63) is formed as a cantilever spring having a cantilever shape or a double-end supported spring having a double-end supported beam shape.

8. The electronic device (10) according to any one of claims 1 to 7, wherein a heat conductive sheet (56) is installed on the heat releasing surface of the heat sink (51).

# Fig. 1

Fig. 2

# Fig. 3

Fig. 4

# Fig. 5

# Fig. 6

Fig. 7

Fig. 8

Fig. 9

# Fig. 10

# Fig. 11

Fig. 12

# Fig. 13

Fig. 14

EP 4 742 846 A1

Fig. 15

EP 4 742 846 A1

# Fig. 16

Fig. 17

Fig. 18

# Fig. 19

Fig. 20

Fig. 21

Fig. 22

EP 4 742 846 A1

Fig. 23

EP 4 742 846 A1

# Fig. 24

Fig. 25

# Fig. 26

Fig. 27

EP 4 742 846 A1

# Fig. 28

EP 4 742 846 A1

Fig. 29

# Fig. 30a

BEFORE FITTING AND IN MIDDLE OF FITTING

EP 4 742 846 A1

# Fig. 30b

FITTED STATE

EP 4 742 846 A1

Fig. 31

## Fig. 32

(A)

(B)

Europäisches
Patentamt

European
Patent Office

Office européen
des brevets

## EUROPEAN SEARCH REPORT

**Application Number**

EP 25 19 5300

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2009/296350 A1 (OKI KAZUSHIGE [JP] ET AL) 3 December 2009 (2009-12-03) * paragraph [0022] - paragraph [0041]; figures 1-6B * | 1-8 | INV. H05K7/20 G02B6/42 G06F1/20 |
| Y | US 10 222 844 B1 (REDDY ANUYA [IN] ET AL) 5 March 2019 (2019-03-05) * paragraph [0003] - paragraph [0006]; figures 1,3,6-8 * | 1-8 | |
| Y | CN 219 876 711 U (INNOLIGHT TECHNOLOGY CORP) 20 October 2023 (2023-10-20) * paragraph [0077] - paragraph [0089]; figures 2,3,9,10 * | 1-8 | |

| | |
|---|---|
| | TECHNICAL FIELDS SEARCHED (IPC) |
| | H05K G02B G06F |

The present search report has been drawn up for all claims

| Place of search | Date of completion of the search | Examiner |
|---|---|---|
| The Hague | 27 January 2026 | Seifert, Frank |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 19 5300

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2026

| Patent document cited in search report | | Publication date | Patent family member(s) | | Publication date |
|---|---|---|---|---|---|
| US 2009296350 | A1 | 03-12-2009 | JP | 4998249 B2 | 15-08-2012 |
| | | | JP | 2009152427 A | 09-07-2009 |
| | | | US | 2009296350 A1 | 03-12-2009 |
| US 10222844 | B1 | 05-03-2019 | NONE | | |
| CN 219876711 | U | 20-10-2023 | CN | 219876711 U | 20-10-2023 |
| | | | WO | 2024234744 A1 | 21-11-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009152427 A